# FASCICULE DE BREVET EUROPEEN

(11) **EP 0 743 683 B1**
(45) Date de publication et mention de la délivrance du brevet: **26.09.2001**
(21) Numéro de dépôt: 96410053.1
(22) Date de dépôt: 15.05.1996
(51) Int. Cl.: H01L 27/02

(54) **Elément de protection de circuit intégré de type MOS**
Schutzelement für eine integrierte Schaltung vom MOS-Typ
Protection element of an integrated circuit of a MOS type

(30) Priorité: 19.05.1995 FR 9506264
(43) Date de publication de la demande: 20.11.1996
(73) Titulaire: STMicroelectronics S.A., 94250 Gentilly (FR)
(72) Inventeur: Papadas, Constantin, 38000 Grenoble (FR); Nikolaidis, Theodoros, 38000 Grenoble (FR)
(74) Mandataire: de Beaumont, Michel

(56) Documents cités:
- EP-A- 0 408 457
- EP-A- 0 543 745

## Description

La présente invention concerne le domaine des circuits intégrés sur un substrat semiconducteur et plus particulièrement la protection contre des surtensions électrostatiques des plots d'entrée/sortie d'un circuit intégré de type MOS.

Il est connu que les broches d'un circuit intégré, quand celui-ci n'est pas encore connecté, sont très sensibles à des phénomènes de décharge électrostatique qui peuvent provenir par exemple d'une manipulation de ces circuits. Ces décharges électrostatiques correspondent à des impulsions de tension à front de montée très rapide mais généralement de relativement faible énergie. En l'absence de protection, le passage de ces impulsions peut provoquer la destruction de composants d'étages d'entrée/sortie ou d'étages internes d'un circuit intégré.

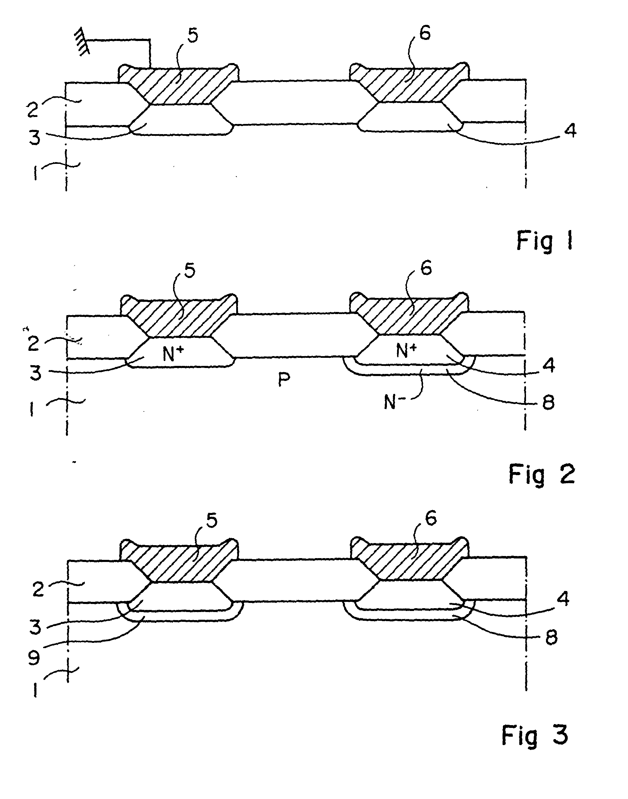

Une des structures classiques les plus simples, adaptée aux technologies MOS, pour résoudre ce type de problème est illustrée en figure 1. Elle peut être considérée comme un transistor MOS sans grille ou un transistor bipolaire NPN latéral. Dans un substrat de silicium 1 d'un premier type de conductivité, que l'on considérera ci-après comme étant le type P, revêtu d'une couche d'oxyde épais 2, sont formées deux régions du deuxième type de conductivité à niveau de dopage élevé 3 et 4, respectivement revêtues de métallisations 5 et 6. Classiquement, le substrat P est connecté à la masse par l'intermédiaire d'une métallisation non représentée ; la métallisation 5 ou source du transistor MOS sans grille 3-1-4 est reliée à la tension d'alimentation la plus négative du circuit (Vss) qui peut par exemple être également la masse ; et la métallisation 6 ou drain est reliée à un plot à protéger, ce plot étant par ailleurs relié à des circuits d'entrée/sortie.

L'objectif est qu'une surtension soit évacuée de la métallisation 6 vers la métallisation 5 avant que les circuits auxquels est connecté le plot soient susceptibles d'être dégradés. Quand une surtension positive arrive sur la borne 6, elle tend à créer des paires électrons-trous dans le substrat 1 au voisinage de sa jonction avec la région 4. Les électrons sont réattirés vers le drain et les trous tendent à se propager dans le substrat et sont pour partie éliminés par la connexion à la masse du substrat. Quand les trous en cours de propagation arrivent au voisinage de la région 3, le transistor bipolaire ayant comme collecteur la région 4, comme base la région 1 et comme émetteur la région 3 entre en conduction et l'on a une élimination rapide des surcharges vers la métallisation 5. Ce type de structure pose divers problèmes de fabrication, de destruction par des surcharges, de dissipation et de rapidité (durée intermédiaire avant l'amorçage du transistor bipolaire susmentionné).

Dans l'art antérieur, on s'est essentiellement soucié du problème de la destruction potentielle des jonctions par perçage à la suite de l'arrivée d'une surtension. En effet, si une surtension arrive sur le drain, le passage d'un courant très élevé peut produire une fusion de la métallisation 6, et sa pénétration dans et à travers la région de drain 4 pour provoquer une mise en court-circuit de la jonction de drain.

Pour résoudre ce problème, il a été prévu (voir "A CMOS VLSI ESD INPUT PROTECTION, DEVICE, DIFIDW" Lin, Chong Ming et al, EOS/ESD Symposium proceedings, 1984, EOS-6, PP 202-209), comme le représente la figure 2, de former un caisson 8 de type N faiblement dopé sous la région de drain 4 de type N⁺ fortement dopé. Ainsi, en raison de l'augmentation de l'épaisseur totale de la région N de drain, les risques de perçage sont réduits. Pour simplifier la fabrication et éviter d'avoir à masquer la région de source pendant que l'on forme le caisson de drain 8, on forme simultanément un caisson 8 autour du drain et un caisson 9 autour de la source, comme le représente la figure 3.

Deux procédés ont été utilisés dans l'art antérieur pour former ces caissons N sous le drain.

Le premier procédé consiste, comme cela est illustré, à utiliser comme masque de définition du ou des caissons la ou les ouvertures formées dans la couche d'oxyde de champ 2. On comprendra que, en raison des limitations que cela impose sur les énergies d'implantation, de tels caissons ne peuvent alors pas être très étendus.

Le second procédé consiste à former le caisson ou les caissons avant de former l'oxyde épais. Ceci entraîne que ces caissons ne seront pas strictement alignés avec les ouvertures de drain et de source dans l'oxyde épais et que l'on doit prévoir des distances de garde plus importantes. Il en résulte que l'écart entre les régions de source et de drain doit nécessairement être augmenté par rapport à la distance possible minimale que l'on vise normalement à utiliser pour réduire la longueur de base du transistor NPN.

Ces structures présentent encore divers inconvénients qui seront exposés plus en détail ci-après.

Un premier inconvénient est que la dissipation d'énergie dans la structure pendant l'absorption de la surcharge n'est pas suffisamment réduite.

Un autre inconvénient est que la rapidité du dispositif, c'est-à-dire la durée entre l'incidence de la surcharge et la mise en conduction du transistor bipolaire susmentionné est trop élevée pour des surcharges intenses et brèves (de l'ordre de la nanoseconde).

Ainsi, un premier objet de la présente invention est de réduire la consommation d'énergie dans un dispositif de protection contre les surtensions.

Un autre objet de la présente invention est d'augmenter la vitesse de commutation d'un dispositif de protection.

Pour atteindre ces objets ainsi que d'autres, la présente invention prévoit un élément de protection correspondant à un transistor MOS élémentaire sans grille dont la région de source est reliée à un potentiel de référence et dont la région de drain est reliée à un plot susceptible de recevoir une surtension. Un caisson faiblement dopé est formé sous la région de source fortement dopée, la région de drain étant constituée seulement d'une région fortement dopée.

Selon un mode de réalisation de la présente invention, le caisson est obtenu par implantation oblique dans une fenêtre ouverte dans un oxyde épais, le substrat étant entraîné en rotation pendant la phase d'implantation.

Selon un mode de réalisation de la présente invention, le substrat est de type P, les régions de source et de drain sont dopées à l'arsenic et le caisson est dopé au phosphore.

Selon un mode de réalisation de la présente invention, l'énergie d'implantation du dopant du caisson est choisie telle que les atomes dopants ne traversent pas l'oxyde épais sous incidence oblique.

Selon un mode de réalisation de la présente invention, l'angle d'implantation du dopant du caisson est choisi dans la plage de 40 à 60°.

Ces objets, caractéristiques et avantages ainsi que d'autres de la présente invention seront exposés en détail dans la description suivante de modes de réalisation particuliers faite, à titre non-limitatif, en relation avec les figures jointes parmi lesquelles :
les figures 1 à 3 sont des vues en coupe illustrant des limiteurs de surtension selon l'art antérieur ;
les figures 4 à 6 illustrent des étapes successives de fabrication d'un limiteur de surtension selon la présente invention ; et
les figures 7 et 8 représentent, respectivement en échelle linéaire et en échelle logarithmique, des caractéristiques courant-tension de limiteurs de tension selon l'art antérieur et selon l'invention.

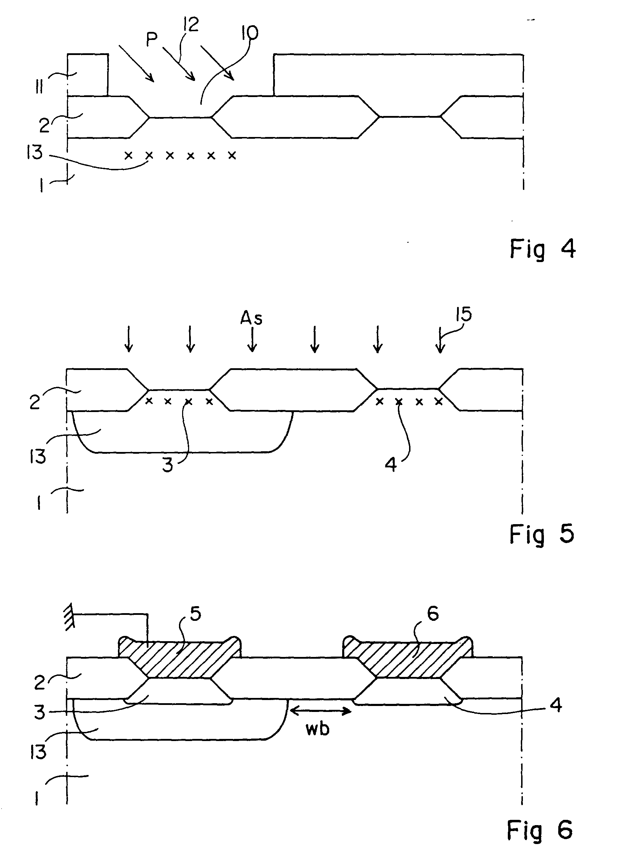

Comme le représente la figure 4, on part selon l'invention d'une tranche de silicium 1 revêtue d'un oxyde épais 2 ouvert aux emplacements où l'on veut former des structures selon la présente invention et en outre, notamment, des régions de sources et de drains de transistors MOS. Selon l'invention, on isole une fenêtre de source 10 ouverte dans la couche d'oxyde épais par une couche de résine photosensible 11. On notera que l'on dispose d'une marge relativement importante pour ouvrir cette couche de résine photosensible qui doit s'arrêter à un emplacement quelconque des couches d'oxyde épais bordant la fenêtre de source 10. On procède ensuite à une implantation sous incidence oblique d'un dopant de type N, par exemple du phosphore, comme cela est indiqué par les flèches 12. Cette implantation oblique est réalisée tandis que le substrat est monté sur un support rotatif et tourne autour d'un axe perpendiculaire à ce substrat. L'énergie d'implantation est choisie pour que les atomes de phosphore ne traversent pas la couche d'oxyde épais 2. On notera que l'on peut quand même choisir une énergie d'implantation élevée car l'épaisseur d'oxyde vue par l'implantation oblique est bien évidemment plus élevée que l'épaisseur transverse de cette couche d'oxyde épais. On obtient ainsi des atomes de phosphore préimplantés 13 débordant par rapport à la dimension minimale de l'ouverture et correspondant sensiblement dans leur étendue latérale aux prolongements obliques de la zone de bec d'oiseau de l'oxyde épais au voisinage de l'ouverture. Cette implantation oblique est réalisée sous un angle de 40 à 60° par rapport à la verticale, par exemple 45°.

Ainsi, après recuit, comme le représente la figure 5, on obtient une région de type N dopée au phosphore 13 nettement plus large que la région que l'on peut obtenir dans le cas d'une implantation normale telle qu'illustrée en figure 2.

Ensuite, on enlève le masque 11 et, comme le représentent les flèches 15 de la figure 5, on procède à une implantation d'arsenic à dose élevée pour créer des régions de type N⁺ illustrées en figure 6 similaires aux régions 3 et 4 décrites en relation avec l'art antérieur. Les métallisations de source et de drain sont désignées par les références 5 et 6 et sont par exemple en tungstène.

Bien entendu, dans ce qui précède, on a prévu l'usage d'un couple de dopants particuliers, le phosphore et l'arsenic, adaptés à la solution du problème posé dans un substrat de type P. On pourrait éventuellement choisir d'autres dopants adaptés ou des dopants de type complémentaire dans le cas d'un substrat de type N.

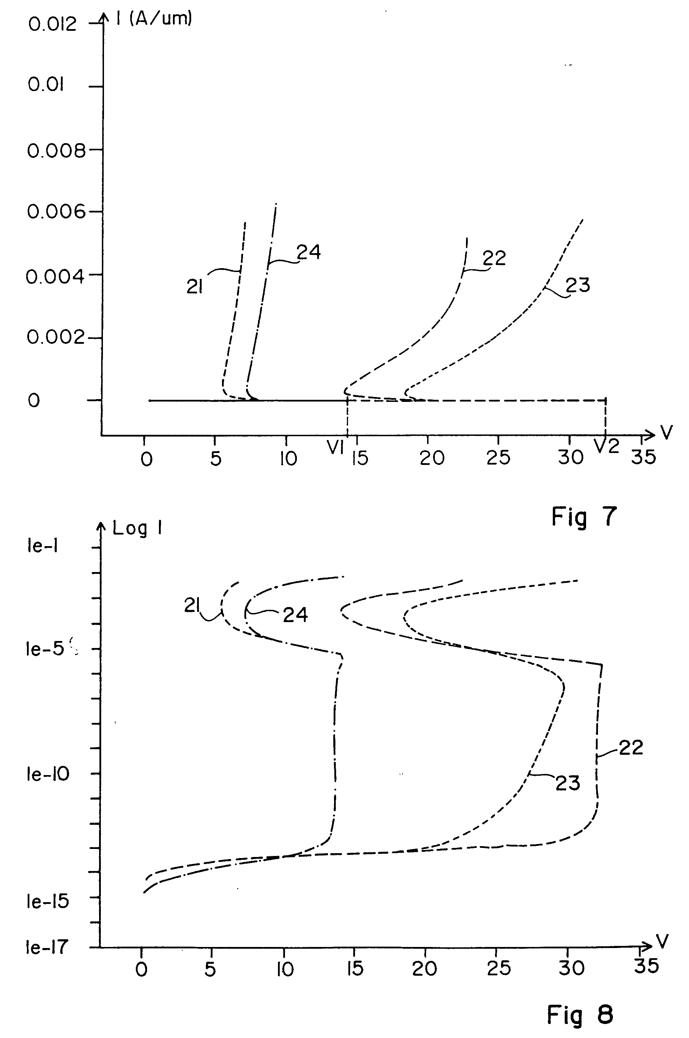

Les avantages d'une structure selon la présente invention par rapport aux structures de l'art antérieur vont être présentés ci-après en relation avec les figures 7 et 8 qui illustrent l'allure du courant par unité de largeur en fonction de la tension entre les bornes de source et de drain lors de l'arrivée d'une surtension. Ces courbes constituent le résultat d'une simulation. On rappelle que l'on se place toujours dans le cas où la borne de source est connectée à la masse et où c'est la borne de drain 6 qui est connectée à un plot susceptible de recevoir une surtension.

En figure 7 les ordonnées sont en échelle linéaire et en figure 8 en échelle logarithmique pour mieux illustrer les phénomènes dans la zone de retournement. Dans ces figures, les courbes 21, 22, 23 et 24 correspondent respectivement au cas des structures des figures 1, 2, 3 selon l'art antérieur et 6 selon l'invention.

Pour la structure de la figure 1 (courbe 21), le seuil d'amorçage du transistor bipolaire 4, 1, 3 correspond à une tension V1 déterminée par la jonction abrupte entre la région de drain 4 et le substrat 1. Une fois cette tension V1 atteinte, la tension chute rapidement puis le courant croît à tension sensiblement constante.

Pour la structure de la figure 2 (courbe 22), le phénomène est similaire sauf que la tension d'amorçage correspond à une valeur V2 notablement supérieure à la valeur V1 en raison de la jonction progressive entre la région N- 8 et le substrat 1. Dans l'exemple choisi où V1 est de l'ordre de 15 V, V2 est supérieur à 30 V.

Pour la structure de la figure 3 (courbe 23), on a sensiblement la même allure que dans le cas de la structure de la figure 2.

Ainsi, la courbe 21 est plus avantageuse en ce que le seuil de tension de retournement est plus faible.

Pour la structure de la figure 6 selon la présente invention (courbe 24), on obtient une tension d'amorçage V1 faible comme dans le cas de la courbe 21, d'où il résulte que la consommation dans la structure pendant la phase d'amorçage sera plus faible que dans les structures de l'art antérieur.

Un autre avantage essentiel de la structure selon la présente invention est que la tension d'amorçage sera atteinte plus vite que dans des structures de l'art antérieur. En effet, cette rapidité dépend essentiellement de la longueur de base du transistor bipolaire désigné par Wb en figure 6. Grâce à la technologie mise en oeuvre (implantation oblique) l'étendue latérale de la diffusion 13 peut être importante alors que la longueur de la zone d'oxyde de champ entre la source et le drain est choisie à la dimension minimale de la technologie considérée. Ceci n'est pas le cas avec les structures des figures 2 et 3 dans lesquelles l'étendue latérale des caissons 8 et/ou 9 est nécessairement limitée. On a également vu que, dans l'état de la technique, il avait été prévu de former des caissons 8 et 9 de grande dimension avant de définir les zones d'oxyde de champ mais dans ce cas, les masques correspondant ne sont pas autoalignés et donc on est obligé de prévoir des gardes supplémentaires et la largeur de la région d'oxyde de champ entre source et drain ne peut plus être conservée à sa valeur minimale.

La structure selon la présente invention ne résout pas de façon intrinsèque le problème du perçage. Ce problème est résolu en choisissant pour la métallisation de drain (et par la même occasion pour les autres métallisations) un métal peu susceptible de fluer dans le drain tel qu'un métal réfractaire, par exemple du tungstène.

Ainsi, la présente invention atteint bien les objets recherchés grâce à la prévision d'un caisson N faiblement dopé au niveau de la source seulement, ce qui fournit l'avantage de faible dissipation, et grâce à la technologie d'implantation oblique qui fournit l'avantage de la rapidité.

## Revendications

1. Elément de protection correspondant à un transistor MOS élémentaire sans grille dont la région de source (3) est reliée à un potentiel de référence et dont la région de drain (4) est reliée à un plot susceptible de recevoir une surtension, **caractérisé en ce qu'**un caisson faiblement dopé (13) est formé sous la région de source fortement dopée, la région de drain étant constituée seulement d'une région fortement dopée.

2. Procédé de fabrication d'un élément de protection selon la revendication 1, **caractérisé en ce que** ledit caisson est obtenu par implantation oblique dans une fenêtre ouverte dans un oxyde épais, le substrat étant entraîné en rotation pendant la phase d'implantation.

3. Procédé selon la revendication 2, dans lequel le substrat est de type P, les régions de source et de drain sont dopées à l'arsenic et le caisson est dopé au phosphore.

4. Procédé selon la revendication 2, **caractérisé en ce que** l'énergie d'implantation du dopant du caisson est choisie telle que les atomes dopants ne traversent pas l'oxyde épais sous incidence oblique.

5. Procédé selon la revendication 2, **caractérisé en ce que** l'angle d'implantation du dopant du caisson est choisi dans la plage de 40 à 60° par rapport à la verticale.

## Patentansprüche

1. Schutzelement, das einem elementaren MOS-Transistor ohne Gate entspricht, dessen Source-Bereich (3) mit einem Bezugspotential und dessen Drain-Bereich (4) mit einem Kontakt-Kissen verbunden ist, das dem Empfang einer Überspannung ausgesetzt sein kann, **dadurch gekennzeichnet, daß** unterhalb dem stark dotierten Source-Bereich ein schwach dotierter Graben (13) ausgebildet ist und daß der Drain-Bereich nur aus einem stark dotierten Bereich besteht.

2. Verfahren zur Herstellung eines Schutzelements nach Anspruch 1, **dadurch gekennzeichnet, daß** der genannte Graben durch schräge Implantation in einem Fenster in einem dicken Oxyd erhalten wird, wobei das Substrat während der Implantationsphase in Rotation versetzt wird.

3. Verfahren nach Anspruch 2, bei welchem das Substrat vom P-Typ ist, der Source- und der Drain-Bereich mit Arsen dotiert sind und der Graben mit Phosphor dotiert wird.

4. Verfahren nach Anspruch 2, **dadurch gekennzeichnet, daß** die Implantations-Energie der Dotierung des Grabens so gewählt wird, daß die Dotierungsatome das dicke Oxyd bei schrägem Einfall nicht durchsetzen.

5. Verfahren nach Anspruch 2, **dadurch gekennzeichnet, daß** der Implantations-Winkel der Dotierung des Grabens im Bereich von 40° bis 60° bezüglich der Vertikalen gewählt wird.

## Claims

1. A protection element corresponding to an elementary gateless MOS transistor having its source region (3) connected to a reference potential and its drain region (4) connected to a pad likely to receive an overvoltage, **characterized in that** a lightly doped well (13) is formed under the highly doped source region, the drain region being constituted by a highly doped region only.

2. A method for manufacturing a protection element according to claim 1, **characterized in that** said well is obtained by oblique implantation in a window open in a thick oxide, the substrate being rotated during the implantation step.

3. A method according to claim 2, wherein the substrate is a P-type substrate, the source and drain regions are doped with arsenic and the well is doped with phosphorus.

4. A method according to claim 2, **characterized in that** the implantation energy of the well dopant is selected such that the doping atoms do not flow obliquely across the thick oxide.

5. A method according to claim 2, wherein the implantation angle of the well dopant is selected in the range from 40 to 60°, while respect to the vertical direction.
